# EUROPEAN PATENT APPLICATION

(11) **EP 2 490 268 A1**
(43) Date of publication of application: **22.08.2012**
(21) Application number: 12153029.9
(22) Date of filing: 30.01.2012
(51) Int. Cl.: H01L 31/18

(54) **Method for fabricating photovoltaic cells**

(30) Priority: 03.02.2011 US 201161439310 P
(71) Applicant: IMEC, 3001 Leuven (BE); Katholieke Universiteit Leuven K.U. Leuven R&D, 3000 Leuven (BE)
(72) Inventor: Prajapati, Victor, Providence, RI Rhode Island 02907 (US)
(74) Representative: Bird Goën & Co

(57) **Abstract**

A method for fabricating a crystalline silicon photovoltaic cell is disclosed, comprising:
- providing a crystalline silicon substrate of a first dopant type;
- performing an implantation step, thereby introducing dopants of a second type opposite to the first type at a front side of the crystalline silicon substrate;
- after the implantation step, depositing a hydrogen containing layer on the front surface of the substrate;
- after depositing the hydrogen containing layer, performing a thermal treatment, thereby electrically activating the dopant of the second type.

## Description

### Technical field of the disclosure

This disclosure relates to methods for fabricating photovoltaic cells.

### Background of the invention

Advanced device structures have been developed for crystalline silicon photovoltaic cells, such as for example PERC (Passivated Emitter and Rear Cell) and PERL (Passivated Emitter Rear Locally diffused cell) structures. Such advanced device structures lead to higher energy conversion efficiencies but require more process steps and thus result in a higher cost as compared to less advanced structures.

There is a need for a reduction of the cost per watt peak of crystalline silicon photovoltaic cells, for example by reducing the fabrication cost and at the same maintaining good energy conversion efficiencies.

### Summary of the disclosure

Certain inventive aspects relate to a method for fabricating crystalline silicon photovoltaic cells wherein the method requires less process steps and has a reduced cycle time as compared to prior art methods and wherein the method allows fabricating photovoltaic cells with good energy conversion efficiency. A method according to one inventive aspect allows reducing the cost per Watt peak of photovoltaic cells.

One inventive aspect relates to a method for fabricating crystalline silicon photovoltaic cells, wherein the method comprises the following steps: providing a crystalline silicon substrate of a first dopant type; performing an implantation step, thereby introducing dopants of a second type opposite to the first type at a front side of the crystalline silicon substrate; after the implantation step, depositing a hydrogen containing layer on the front surface of the substrate; after depositing the hydrogen containing layer, performing a thermal treatment, thereby electrically activating the dopant of the second type. After the ion implantation step, the dopants are located at interstitial sites in the silicon lattice; in order to make the dopants electrically active they need to be at substitutional sites in the silicon lattice. This is obtained by the annealing step.

Already in the 80's, research relating to the use of implantation for emitter formation in solar cells was done. However, these activities were abandoned because it was believed that implantation was too slow and too costly for industrial production of photovoltaic cells. Today, high-throughput implanters become available, which makes their introduction in an industrial photovoltaic cell production line viable.

The crystalline silicon substrate of the first dopant type can be a p-type substrate and the dopant of the second type can be an n-type dopant such as for example Phosphorous or any other suitable dopant known to a person skilled in the art. Alternatively, the crystalline silicon substrate of the first dopant type can be an n-type substrate and the dopant of the second type can be an p-type dopant such as for example Boron or any other suitable dopant known to a person skilled in the art. The crystalline silicon substrate can for example be a monocrystalline substrate or a multicrystalline substrate.

The front surface or front side of a substrate or of a photovoltaic cell is the surface or side adapted for being oriented towards a light source and thus for receiving illumination. The back surface, back side, rear surface or rear side of a substrate or of a photovoltaic cell is the surface or side opposite to the front surface.

The hydrogen containing layer can for example be a hydrogen-rich silicon nitride layer. It may act as an antireflection coating (ARC) and/or as a front surface passivation layer. The hydrogen containing layer can for instance have a thickness within the range between 10 nm and 150 nm, more preferably between 50 nm and 90 nm.

The implantation step leads to a creation of defects in the silicon substrate and results in an amorphous layer being formed in a surface portion of the silicon substrate. During ion implantation, accelerated ions collide with atoms of the substrate and displace them from the original lattice sites: this leads to the formation of for instance point defects (interstitials and vacancies) and line defects (dislocations) and it can lead to the formation of an amorphous layer. The thermal treatment leads to electrical activation of the dopant of the second type and thus the formation of an emitter region at the front side of the substrate. In addition, the thermal treatment leads to a release of hydrogen from the hydrogen containing layer, resulting in passivation of defects at the front side of the substrate, such as for example defects induced by the implantation step. Such process can comprise the passivation of dangling bonds by attachment of hydrogen to the dangling bonds, making these defects electrically inactive. A similar mechanism (attachment of hydrogen) may also passivate (i.e. make electrically inactive) point defects and/or dislocations. The thermal treatment may also lead to annealing of damage caused by the implantation step and to recrystallization of the amorphous layer formed as a result of the implantation step.

The thermal treatment may comprise a rapid thermal processing (RTP) or rapid thermal annealing (RTA) step or process, or similar thermal treatment known to the skilled person. The thermal treatment can for instance be performed at a temperature (peak temperature) in the range between about 600°C and 1100°C, or between 800°C and 1050°C, e.g. between 850°C and 1000°C for a duration of a few tens of seconds (for instance 10 seconds, 20 seconds, 30 seconds or 40 seconds) to a few minutes (for instance 1, 2, 3, 4, 5 minutes), for example about 1 minute. The duration can be for instance in the range between 1 second and 10 minutes, more preferably in the range of 10 seconds to 5 minutes, or in the range of 30 seconds to 200 seconds. However, the present disclosure is not limited thereto, and other methods and tools may be used for performing the thermal treatment. It is an advantage of using RTP or RTA that it allows reducing the process time as compared to other methods.

According to preferred embodiments, the step of implantation generates a shallow region corresponding to an emitter region of said crystalline silicon photovoltaic cell having a depth in between 30 nm to 300 nm, i.e. before thermal treatment. The depth can be for instance within the range of 30nm to 500nm, preferably in the range of 50nm to 300nm, more preferably between 75nm and 200 nm.

According to preferred embodiments, after thermal treatment, an emitter region of the crystalline silicon photovoltaic cell having a depth in between 75 nm to 750 nm, more preferably in between 100 nm to 500 nm, even more preferably in between 100 nm to 300 nm is generated.

In embodiments of the present disclosure the process time or cycle time can be further reduced by avoiding the need for a separate thermal treatment step or process such as an RTP step or process. The thermal treatment step can be combined with one of the subsequent steps in the fabrication process such as for example a contact firing step or process. For example, after depositing the hydrogen containing layer, a metal layer can be deposited at the rear side of the substrate, followed by a metal firing step for forming good contacts and eventually for creating BSF (back surface field) regions. This metal firing step can have the function of the thermal treatment step, such that the need for a separate thermal treatment step is avoided.

Or, in particular in the context of manufacturing a photovoltaic device of the PERC-type, the method can further comprise
- providing a passivation layer or passivation stack at the rear side;
- performing a rear side metallization step and a front side metallization step;
- co-firing of the rear side metallization and the front side metallization, for instance at a temperature in the range between 600°C and 1100°C.

The method may further comprise a step of texturing of the front side of the substrate.

The method may further comprise a step of depositing an antireflection coating (ARC), at the front side or surface of the photovoltaic device. The hydrogen containing layer can itself correspond to an antireflection coating, in other words the hydrogen containing layer be an antireflection coating. In those cases no separate ARC may be required.

According to preferred embodiments of the present invention, said passivation layer or passivation stack at the rear side is provided before performing said thermal treatment. The passivation layer can be provided before or after deposition of the hydrogen containing layer.

It is an advantage of a method according to one inventive aspect that it can reduce the cost per Wp of photovoltaic cells, by reducing the number of process steps and thus the cycle time of the complete process, by using less cleaning steps (and thus less chemicals and water), and by using less costly (e.g. less energy consuming) processes. For example, the cycle time is reduced by replacing an emitter diffusion step requiring typically one hour in a diffusion furnace by an about 30 second, one sided, low temperature implantation step and eventually an about 1 minute RTP step. In certain embodiments, the need for an additional thermal treatment for drive-in of the implanted dopants is avoided.

It is an advantage of a method according to one inventive aspect that the front side of the substrate is covered by a hydrogen containing layer before any high-temperature process step is performed. This allows reducing contamination of the substrate, such as for example contamination by metal impurities.

According to preferred embodiments of the present invention, depositing a hydrogen containing layer on the front surface of the substrate is performed directly after said implantation step.

Certain advantages have been described herein above. Of course, it is to be understood that not necessarily all such objects or advantages may be achieved in accordance with any particular embodiment of the disclosure. Thus, for example, those skilled in the art will recognize that the disclosure may be embodied or carried out in a manner that achieves or optimizes one advantage or group of advantages as taught herein without necessarily achieving other objects or advantages as may be taught or suggested herein. Further, it is understood that this summary is merely an example and is not intended to limit the scope of the disclosure. The disclosure, both as to organization and method of operation, together with features and advantages thereof, may best be understood by reference to the following detailed description when read in conjunction with the accompanying drawings.

### Brief description of the drawings

Figure 1 illustrates an exemplary fabrication process for photovoltaic cells in accordance with one embodiment.
Figure 2 shows measured open-circuit voltages for photovoltaic cells with an implanted emitter, as a function of implantation energy and for different thermal treatments.
Figure 3 shows measured short-circuit currents for photovoltaic cells with an implanted emitter, as a function of implantation energy and for different thermal treatments.
Figure 4 shows measured efficiencies for photovoltaic cells with an implanted emitter, as a function of implantation energy and for different thermal treatments.
Figure 5 illustrates SIMS profiles of hydrogen and phosphorus, comparing diffused and implanted samples before and after firing.
Figure 6 depicts a process flow comparison for traditionally diffused PERC cells (a) versus implanted PERC cells (b).
Figure 7 shows Transmission Electron Microscopy (TEM) images comparing a traditionally diffused and fired sample with an implanted sample before and after firing.

In the different drawings, the same reference signs refer to the same or analogous elements.

### Description of illustrative embodiments

In the following detailed description, numerous specific details are set forth in order to provide a thorough understanding of the disclosure and how it may be practiced in particular embodiments. However, it will be understood that the present disclosure may be practiced without these specific details. In other instances, well-known methods, procedures and techniques have not been described in detail, so as not to obscure the present disclosure. While the present disclosure will be described with respect to particular embodiments and with reference to certain drawings, the disclosure is not limited hereto. The drawings included and described herein are schematic and are not limiting the scope of the disclosure. It is also noted that in the drawings, the size of some elements may be exaggerated and, therefore, not drawn to scale for illustrative purposes.

Furthermore, the terms first, second, third and the like in the description, are used for distinguishing between similar elements and not necessarily for describing a sequence, either temporally, spatially, in ranking or in any other manner. It is to be understood that the terms so used are interchangeable under appropriate circumstances and that the embodiments of the disclosure described herein are capable of operation in other sequences than described or illustrated herein.

Moreover, the terms top, bottom, over, under and the like in the description are used for descriptive purposes and not necessarily for describing relative positions. It is to be understood that the terms so used are interchangeable under appropriate circumstances and that the embodiments of the disclosure described herein are capable of operation in other orientations than described or illustrated herein.

It is to be noticed that the term "comprising" should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B.

Certain embodiments relate to a method for fabricating crystalline silicon photovoltaic cells, wherein the method comprises: providing a crystalline silicon substrate of a first dopant type; performing an implantation step, thereby introducing dopants of a second type at a front side of the crystalline silicon substrate (emitter implantation step); deposition of a hydrogen containing layer on the front surface of the substrate; and afterwards performing a thermal treatment or thermal annealing step.

The emitter implantation step provides emitter dopants into the silicon substrate and causes implantation damage. It leads to the creation of defects in the silicon substrate and results in amorphization of a surface portion of the substrate. The hydrogen containing layer can act as an ARC and/or as a surface passivation layer. It can for example comprise a hydrogen rich SiNₓ layer, e.g. deposited by PECVD using SiH₄ and NH₃. However, the present disclosure is not limited thereto: other materials can be used for forming the hydrogen containing layer and other suitable methods can be used for depositing the hydrogen containing layer. In advantageous embodiments, the thermal annealing step can be a rapid thermal annealing step or it can be another step of the fabrication process, such as for example a firing step, e.g. used for firing metal contacts. During the thermal annealing step, defects, e.g., induced by the implantation step, may be passivated by hydrogen being released from the hydrogen containing layer, thus leading to a good passivation of the emitter. The thermal annealing may also lead to a (partial) recrystallization of the amorphous silicon layer resulting from the implantation step. In addition, the thermal annealing results in electrical activation of the emitter dopants.

It is an advantage of a method according to one embodiment that it offers a high throughput, that the need for a dedicated dopant drive-in step is avoided, and that the need for dedicated implantation damage annealing and/or implantation damage etching is avoided. Although there is no dedicated damage annealing step, there is also no need for damage etching. It is also an advantage that the thermal annealing step is performed after providing a hydrogen containing layer at the front surface, such that this layer can act as a barrier (can be a barrier layer) for contamination, e.g. metal contamination. The method according to one embodiment allows fabricating silicon photovoltaic cells with good energy conversion efficiencies.

The method is further described for an exemplary embodiment wherein the method is used in a fabrication process for PERC-type photovoltaic cells. However, the present disclosure is not limited thereto and the method can be used in a fabrication process for other photovoltaic cell structures.

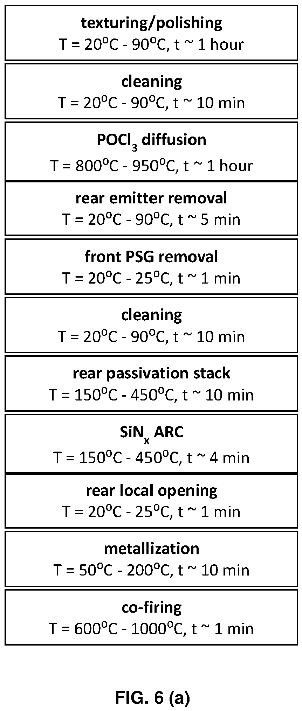

A typical prior art PERC process flow is schematically illustrated in FIG. 6(a). It comprises: single side texturing of a substrate (e.g. silicon wafer); performing a cleaning step; emitter diffusion at a temperature in the range between 800°C and 950°C in a POCl₃ diffusion furnace, resulting in doped region both at the front side and at the rear side of the substrate; removal of the doped (emittter) region at the rear side; removal of the PSG (PhosphoSilicate Glass) formed during emitter diffusion at the front surface; performing a cleaning step; providing a passivation stack at the rear side; depositing an ARC (antireflection coating), e.g. a SiNx ARC at the front side; local opening of the passivation stack at the rear side, for example by laser ablation; performing a rear side metallization step and a front side metallization step; and co-firing of the rear side metallization and the front side metallization at a temperature in the range between 600°C and 1000°C.

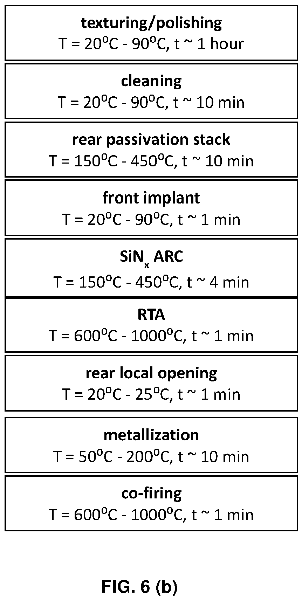

FIG. 6(b) illustrates a PERC process flow with an emitter formed by ion implantation according to an embodiment of the present disclosure. After single side texturing and cleaning of the substrate, a passivation layer or passivation stack is provided on the back or rear surface of the substrate. Then a front surface implantation step is done, followed by a deposition or formation step of a hydrogen containing antireflection coating (ARC), such as a hydrogen containing SiNₓ ARC, which is moreover adapted or optimized to provide the advantages and effects as described before for embodiments of the present invention. A Rapid Thermal Anneal activation step is then applied. The rear side passivation layer is opened locally and a metallization step is performed at the back surface and at the front surface. This is followed by a contact co-firing step.

In such a prior art process flow as illustrated in FIG. 6(a), one of the most time consuming steps is the emitter diffusion, which has a duration of the order of one hour or more. In addition, because emitter diffusion is a double sided process, an additional process step is needed to remove the emitter region at the rear side.

Therefore, in certain embodiments a front implantation step only requiring a few seconds is performed to provide emitter dopants. In addition the use of a dedicated step for driving in the dopants and/or for removing implantation damage is avoided. Instead, a rapid thermal processing (RTP) step or one of the steps performed at a later stage of the process (such as for example a metal firing step) is used to activate the emitter dopants and to form an emitter junction of good quality. Such a RTP or RTA step can be a single sided process.

Furthermore, in certain embodiments, a hydrogen containing layer, e.g. acting as an antireflection coating (ARC), is provided on the front surface after emitter implantation and before performing any further thermal treatment. Therefore, as an additional result of the thermal treatment, defects generated by the implantation step (implantation damage) are passivated by hydrogen that is released from the hydrogen containing layer, leading to a good surface passivation. Furthermore, using the process sequence according to one embodiment, high-temperature steps are performed only after providing the hydrogen containing layer. The hydrogen containing layer can therefore act as a barrier against contamination, e.g. metal or other contamination which may be possible during further processing or because of the mere presence of possible contaminants in the environment of the photovoltaic cell during fabrication.

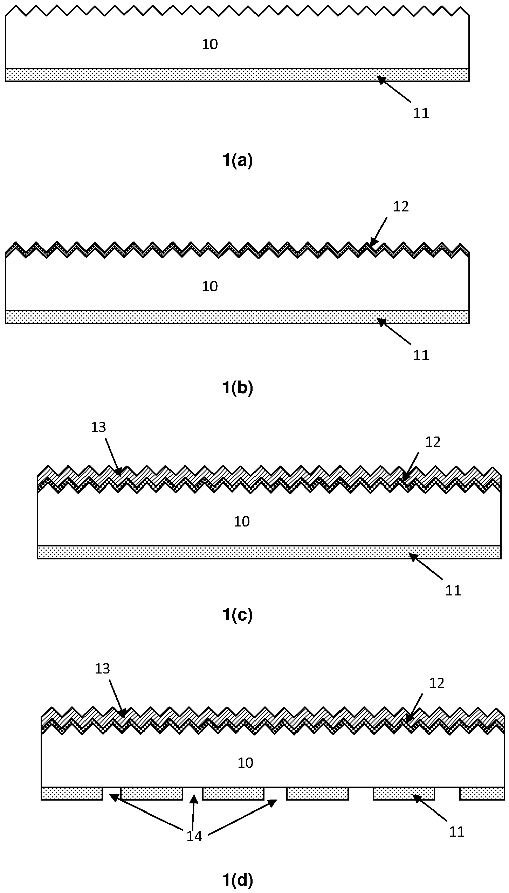

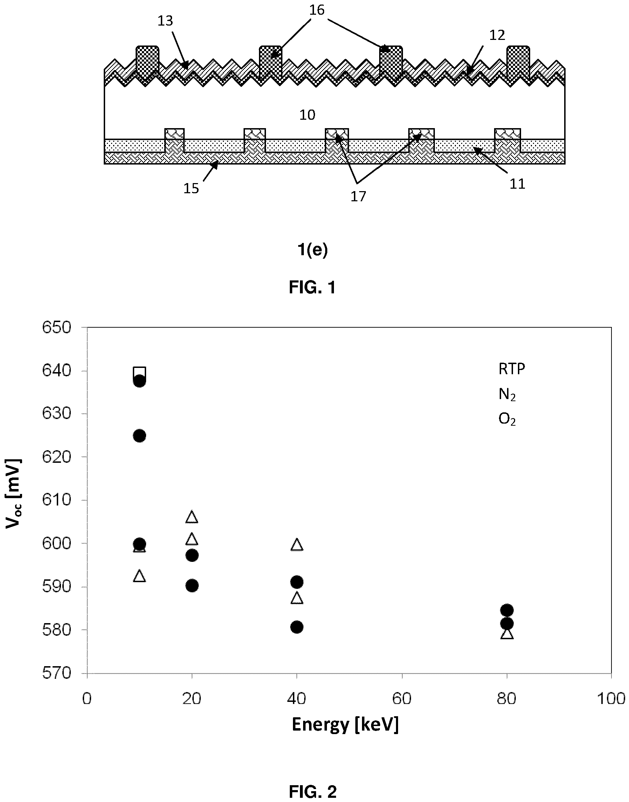

An example of a process sequence in accordance with one embodiment is illustrated in Figure 1 for a PERC-type photovoltaic cell. After single-side texturing of a silicon substrate 10, a passivation layer or a passivation stack 11, such as for example a SiOₓ/SiN stack or an AlOₓ/SiN stack, is provided at the rear side of the substrate (Figure 1(a)). Next a dopant implantation step is performed at the front side of the substrate, thereby forming an implanted region 12 (Figure 1(b)). Implantation can for example be done using an implantation energy in the range between about 5 keV and 100 keV, e.g. between about 5 keV and 50 keV, and an implantation dose in the range between about 10¹⁴ cm⁻² and 10¹⁶ cm⁻². Next a hydrogen containing ARC 13, such as for example a PECVD SiNₓ layer, is provided at the front side (Figure 1(c)). After providing the hydrogen containing layer, a thermal treatment such as for example a rapid thermal annealing is performed, e.g. at a temperature in the range between about 600°C and 1000°C. This thermal treatment results in electrical activation of the implanted dopants, it causes release of hydrogen from the hydrogen containing layer 13 and passivation by the hydrogen of defects created during the implantation step, and recrystallization of the amorphous silicon surface layer resulting from the implantation step. After that, in order to form local back contacts, local openings 14 are provided in the rear side passivation stack 11 (Figure 1(d)). These openings can for example be made by laser ablation or by any other suitable method known to a person skilled in the art. Next, the rear side metallization 15 and front side metallization 16 are provided (Figure 1(e)) and a metal co-firing step is performed, for example at a temperature in the range between about 600°C and 1000°C. In case the rear side metallization 15 comprises Al, this metal co-firing step can also result in the formation of local BSF (back surface field) regions 17 (Figure 1(e)).

In a process according to one embodiment, the dopant activation occurs in the presence of a hydrogen rich SiNₓ layer. This allows for defects (dangling bonds, implantation damage) to be passivated by hydrogen that is released from SiNₓ at high temperature.

In certain embodiments, the rapid thermal annealing step can be omitted from the process. Instead the metal firing step can also lead to activation of the emitter dopants, passivation of defects and recrystallization of the amorphous silicon layer. Therefore, in such embodiments, the need for a separate thermal treatment such as a rapid thermal annealing step can be avoided.

In one embodiment, BSF regions can for example be formed (before metallization) by an implantation step followed by rapid thermal annealing (RTA) at a temperature in the range between about 600°C and 1000°C. Such an RTA step also provides annealing of implantation damage (both at the front side and the rear side) and electrical activation of the dopants (both at the front side and the rear side), and it can replace the RTA step performed before local opening of the rear side passivation layer described above.

Although certain embodiments are described here for photovoltaic cells with local BSF and local back contacts, the method can also be used in a fabrication process for other photovoltaic cell types, for example for cells with global (i.e. non-local) BSF and rear contacts.

Experiments were performed wherein PERC-type photovoltaic cells (148.25 cm²) with Al BSF were fabricated according to the process flow shown in Figure 1. Phosphorous was implanted at the front side of Cz silicon substrates, using different implantation doses (2e¹⁵ and 9e¹⁴) and different implantation energies (10 keV, 20 keV, 40 keV and 80 keV). After depositing a hydrogen-rich PECVD SiNₓ layer at the front surface, different thermal treatment steps (different annealing conditions) were used for different cells: annealing at 1000°C for 120 minutes in a nitrogen atmosphere; annealing at 1000°C for 120 minutes in an oxygen atmosphere; and rapid thermal annealing at 980°C for 1 minute.

The implantation step results in a shallower doping profile, especially at lower energies as compared to a doping profile obtained after a traditional diffusion process. For example, in the experiments performed, the junction depth after implantation was in the range between about 30 and 300 nm, and after RTA it was in the range between about 100 nm and 500 nm.

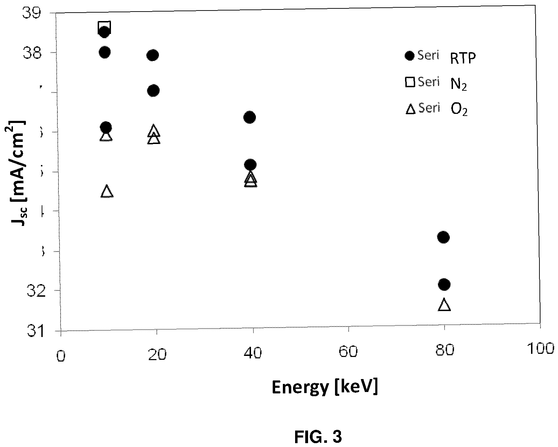

Figure 2 shows the measured open-circuit voltages V_{oc} and Figure 3 shows the measured short-circuit current densities J_{sc} as a function of the implantation energy, for the different annealing conditions. From these results it can be concluded that photovoltaic cells with good energy conversion efficiencies can be fabricated by using ion implantation and RTA for forming an emitter in accordance with one embodiment. This indicates that the defects created during these implantations can be annealed to a sufficient level to achieve an acceptable front surface recombination velocity and thus a good open-circuit voltage and a good short-circuit current. For the lower implantation energies, higher open-circuit voltages and higher short-circuit current densities are obtained as compared to higher implantation energies.

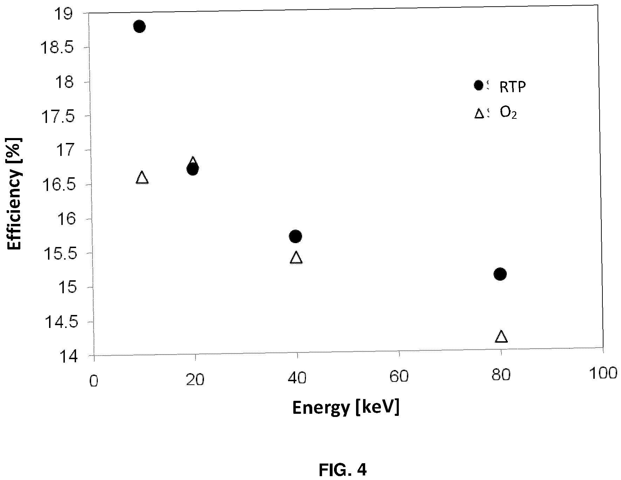

The highest cell efficiencies obtained in these experiments, for cells with different implantation energies and different annealing conditions are shown in Figure 4. For the best cell fabricated in these experiments according to a method of one embodiment, an energy conversion efficiency of about 18.8 % was obtained, with a short-circuit current density J_{sc} of about 38.5 mA/cm², an open-circuit voltage V_{oc} of about 638 mV and a fill factor of about 76.6%.

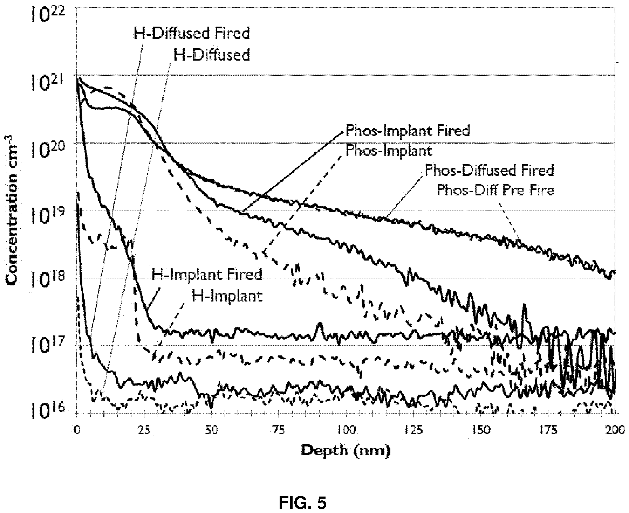

Figure 5 illustrates secondary ion mass spectroscopy (SIMS) profiles of hydrogen and phosphorus, comparing diffused and implanted samples before and after firing, at different processing stages of a diffused and implanted emitter. Mirror polished, 800um thick, wafers were either implanted or diffused in a POCl₃ furnace. Wafers were deposited with PECVD SiNₓH_{y} and then annealed in a firing furnace at 950C for 90seconds. SIMS measurements were performed before and after the anneal. The dose for this particular phosphorus implantation was 1.17×10¹⁵cm⁻². The data suggest that diffused samples have a low amount of H₂ injected into the wafer after firing in contrast to implanted samples. The SIMS shows that after SiNₓH_{y} deposition there is box profile of hydrogen in the implanted samples. The amorphous Si acts as a hydrogen trap, and during annealing the a-Si is re-crystallized. The data show that hydrogen remains in the first 20 nm after annealing and activation. It is believed that it plays a role in passivation.

It will be appreciated that process flows according to embodiments of the present invention differ from the traditional flow of diffusion in that the deposition of the passivation stack can be performed before emitter formation. This allows for the removal of at least one cleaning step when compared to the traditional diffusion scenario. The rear-side interface of the photovoltaic device is already well defined, the wafers can undergo implantation and then a subsequent hydrogen rich SiNₓH_{y} layer can be deposited on the front side. Wafers are completely covered by this passivation layer and can thus enter a dirty metallization furnace for rapid thermal activation without risk of contamination resulting in degradation.

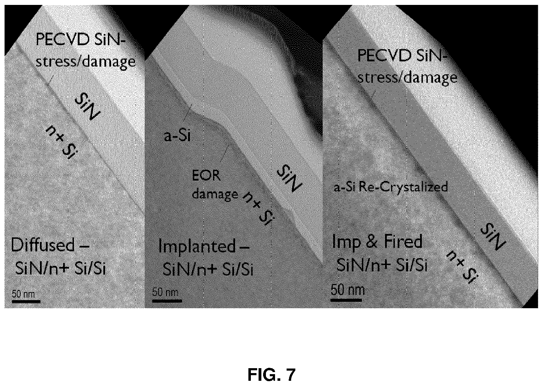

Figure 7 shows the transmission electron microscopy (TEM) images comparing a POCl₃ diffused wafer to an implanted wafer before and after firing. The diffused sample seems to have some induced PECVD SiN stress/damage that incurs in the first few nanometers of the silicon. It shows a clear disruption in the crystal lattice. The second image shows an implanted (10 keV 2e15) wafer, the first 20nm of silicon is amorphized (is made amorphous) by the implantation and there is evidence of end of range damage (EOR). EOR damage is damage that has been caused by ion implanted species colliding with silicon atoms, but has not disturbed the crystallinity of the structure. The final image is of the implanted wafers fired, the amorphous layer has been fully re-crystallized although there does seem to be a brighter contrast layer in the first 50nm below the SiN; this is believed to be due to hydrogenation of the first tens of nanometers of silicon during the annealing step.

It will be appreciated that advantages of the proposed process flows over traditional diffusion are that implantation is a one sided, faster, lower temperature process that can save materials (water, acids, silicon) and relax constraints in manufacturing. Another advantage is hydrogenation of the first tens of nm into the silicon and the possibility of replacing a diffusion or oxidation furnace all together with a metal firing furnace.

The foregoing description details certain embodiments of the invention. It will be appreciated, however, that no matter how detailed the foregoing appears in text, the invention may be practiced in many ways. It should be noted that the use of particular terminology when describing certain features or aspects of the invention should not be taken to imply that the terminology is being re-defined herein to be restricted to including any specific characteristics of the features or aspects of the invention with which that terminology is associated.

While the above detailed description has shown, described, and pointed out novel features of the invention as applied to various embodiments, it will be understood that various omissions, substitutions, and changes in the form and details of the device or process illustrated may be made by those skilled in the technology without departing from the spirit of the invention.

## Claims

1. A method for fabricating a crystalline silicon photovoltaic cell, comprising:
- providing a crystalline silicon substrate of a first dopant type;
- performing an implantation step, thereby introducing dopants of a second type opposite to the first type at a front side of the crystalline silicon substrate;
- after the implantation step, depositing a hydrogen containing layer on the front surface of the substrate;
- after depositing the hydrogen containing layer, performing a thermal treatment, thereby electrically activating the dopant of the second type.

2. A method according to claim 1, wherein deposition said hydrogen containing layer comprises depositing a hydrogen-rich silicon nitride layer.

3. A method according to any of the previous claims, wherein providing said hydrogen containing layer comprises providing an antireflection coating (ARC) and/or a front surface passivation layer.

4. A method according to any of the previous claims, wherein performing said thermal treatment comprises a rapid thermal processing (RTP) or rapid thermal annealing (RTA) step.

5. A method according to any of the previous claims, wherein said thermal treatment is performed at a temperature in the range between about 600°C and 1100°C for a duration of a few tens of seconds to a few minutes.

6. Method according to any of the previous claims, generating a shallow region corresponding to an emitter region of said crystalline silicon photovoltaic cell having a depth in between 30 nm to 500 nm, before thermal treatment.

7. Method according to any of the previous claims, generating an emitter region of said crystalline silicon photovoltaic cell having a depth in between 75 nm to 750 nm, after thermal treatment.

8. A method according to any of the previous claims, wherein the crystalline silicon substrate of the first dopant type is a p-type substrate and the dopant of the second type is a n-type dopant.

9. A method according to any of claims 1 to 7, wherein the crystalline silicon substrate of the first dopant type is an n-type substrate and the dopant of the second type is a p-type dopant.

10. A method according to any of the previous claims, wherein said crystalline silicon substrate comprises a mono crystalline substrate or a multi crystalline substrate.

11. A method according to any of the previous claims, wherein depositing a hydrogen containing layer on the front surface of the substrate is performed directly after said implantation step.

12. A method according to any of the previous claims, comprising combining said thermal treatment with one of the subsequent steps in the fabrication process.

13. A method according to claim 12, further comprising depositing a metal layer at a rear side of the substrate, and performing a metal firing step, wherein said metal firing step corresponds to said thermal treatment.

14. A method according claim 12, further comprising
- providing a passivation layer or passivation stack at the rear side;
- performing a rear side metallization step and a front side metallization step;
- co-firing of the rear side metallization and the front side.

15. Method according to claim 14, wherein said passivation layer or passivation stack at the rear side is provided before performing said thermal treatment.
